(19) Europäisches Patentamt / European Patent Office / Office européen des brevets

(11) **EP 4 671 922 A1**

(12) **EUROPEAN PATENT APPLICATION**

(43) Date of publication:
**31.12.2025   Bulletin 2026/01**

(21) Application number: **25178437.7**

(22) Date of filing: **23.05.2025**

(51) International Patent Classification (IPC):
**G06F 1/20** (2006.01)          **C01B 33/158** (2006.01)
**C01B 33/159** (2006.01)          **C08G 77/02** (2006.01)
**C08G 77/04** (2006.01)          **C09D 183/04** (2006.01)

(52) Cooperative Patent Classification (CPC):
**C01B 33/159; C01B 33/1585; C08G 77/02;
C08G 77/04; C09D 183/04; G06F 1/206;**
C01P 2006/32

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **28.06.2024   US 202418759055**

(71) Applicant: **INTEL Corporation
Santa Clara, CA 95054 (US)**

(72) Inventors:
• **SAHA, Krishnendu**
  **560048 Bengaluru (IN)**
• **HOLLA, Chethan**
  **560103 Bangalore (IN)**
• **THAKUR, Hari Shanker**
  **560067 Bengaluru (IN)**

(74) Representative: **HGF
HGF Limited
4th Floor, 1 City Square
Leeds LS1 2AL (GB)**

(54) **AEROGEL INCLUDING LOW THERMAL CONDUCTIVITY GASES AND RELATED APPARATUS AND METHODS**

(57)   Aerogel including low thermal conductivity gases and related apparatus and methods are disclosed. An example aerogel disclosed herein includes a framework including a plurality of pores and a gas in at least one of the plurality of pores, the gas having a lower thermal conductivity than air.

FIG. 1

EP 4 671 922 A1

**Description**

BACKGROUND

Aerogel is an ultralight, porous material that has a low density and low thermal conductivity. Aerogels are composed of large, crosslinked macromolecule frames. The frames of aerogels can be manufactured from a variety of materials, such as silica, carbon, metal oxides, and organic polymers. Aerogels have a variety of commercial and industrial applications including use in insulators, filtration units, chemical catalysts, and electronic devices.

BRIEF DESCRIPTION OF THE DRAWINGS

FIG. 1 is a block diagram of an example electronic device that includes an example aerogel block constructed in accordance with teachings of this disclosure.
FIG. 2A is a schematic diagram of an example implementation of an internal structure of the aerogel of FIG. 1.
FIG. 2B is a schematic diagram of the aerogel of FIG. 1 including an example seal.
FIG. 3 is a schematic diagram of an example system that can be used to produce the aerogel of FIG. 1.
FIG. 4 is a perspective exploded view of an example implementation of a chamber assembly of the system of FIG. 3.
FIG. 5 is a perspective schematic view of the chamber of FIG. 4 depicting the flow of a gas through an aerogel block.
FIG. 6 is a graph depicting the relationship between exposure duration, exposure pressure, and the thermal conductivity of an aerogel block exposed to xenon gas via the system of FIG. 4.
FIG. 7 is a graph depicting a difference in thermal conductivity between sealed aerogel blocks exposed to xenon gas and unsealed aerogel blocks exposed to xenon gas.
FIG. 8 is a graph depicting the thermal conductivity of a sealed aerogel block over time.
FIG. 9 is a flowchart representative of an example manufacturing process for manufacturing the aerogel block of FIG. 1 via the system of FIG. 3.
FIG. 10A is a schematic diagram depicting a thermal map of an electronic device including a prior aerogel block.
FIG. 10B is a schematic diagram depicting a thermal map of the electronic device of FIG. 1 including the aerogel block of FIG. 1.
FIG. 11A is a schematic diagram of an example first system including an aerogel block implemented in accordance with teachings of this disclosure.
FIG. 11B is a schematic diagram of an example second system including an aerogel block implemented in accordance with teachings of this disclosure.
FIG. 11C is a schematic diagram of an example third system including an aerogel block implemented in accordance with teachings of this disclosure.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

DETAILED DESCRIPTION

Many consumer electronic devices, such as laptops and smartphones, are limited in their performance by the temperature of their exterior surfaces. As used herein, the tolerable temperature limit for the skin of a user of a consumer electronic device is referred to as "the ergometric limit." Some electronic devices throttle (e.g., reduce the performance and power output of, etc.) the integrated circuit packages associated therewith to maintain the temperature of the housing of the electronic device below the ergonomic limit. If the ergonomic limit is exceeded, a user of an electronic device can experience physical discomfort. The ergometric limit of an electronic device can vary based on regulations, manufacturer preferences, the form factor of the electronic device, and/or the material of the housing of the electronic device. The ergometric limits of electronic devices can be between approximately 35 degrees Celsius (95 degrees Fahrenheit) and 50 degrees Celsius (122 degrees Fahrenheit).

In recent years, aerogels have been investigated as thermal insulators for consumer electronic devices. Some commercially available silica-based aerogels have thermal conductivities (e.g., ~0.020 Watts/meter-Kelvin, etc.) that are lower than the thermal conductivity of air (e.g., ~0.026 Watts/meter-Kelvin, etc.), which makes aerogel a superior insulator than an air gap in electronic devices. The use of such aerogels as insulators in electronic devices enables the integrated circuit packages of such devices to operate at greater junction temperatures without the temperature of the housing of the electronic device exceeding the ergonomic limit. That is, the superior insulating capabilities of aerogel increase the relative portion of the heat generated by the electronic device dissipated by the cooling system of the electronic device and decrease the relative portion of such heat dissipated into the skin of a user of the device. Prior aerogels are transparent and/or opaque. Because such aerogels are porous, the internal pores of known aerogels are filled with air, which limits the insulative properties of these aerogels.

Examples disclosed herein include aerogels that have been enriched with gases that have thermal conductivities lower than the thermal conductivity of air. Some example aerogels disclosed herein include pores filled with xenon and have significantly lower thermal conductivities than prior aerogels. Some example aerogels disclosed herein include a polymer seal that mitigates leakage of the enriched gases from the aerogel. Example electronic devices disclosed herein include insulator layers with xenon gas enriched aerogels that are disposed between the integrated circuit package and the exterior housing of the electronic device. An example method disclosed herein includes operations to enrich aerogel with a gas and coat the aerogel in a polymer seal. Example aerogels disclosed herein have significantly lower thermal conductivities than prior aerogels, which enables electronic devices including such aerogels to operate at higher junction temperatures without exceeding the ergonomic limit of the electronic devices.

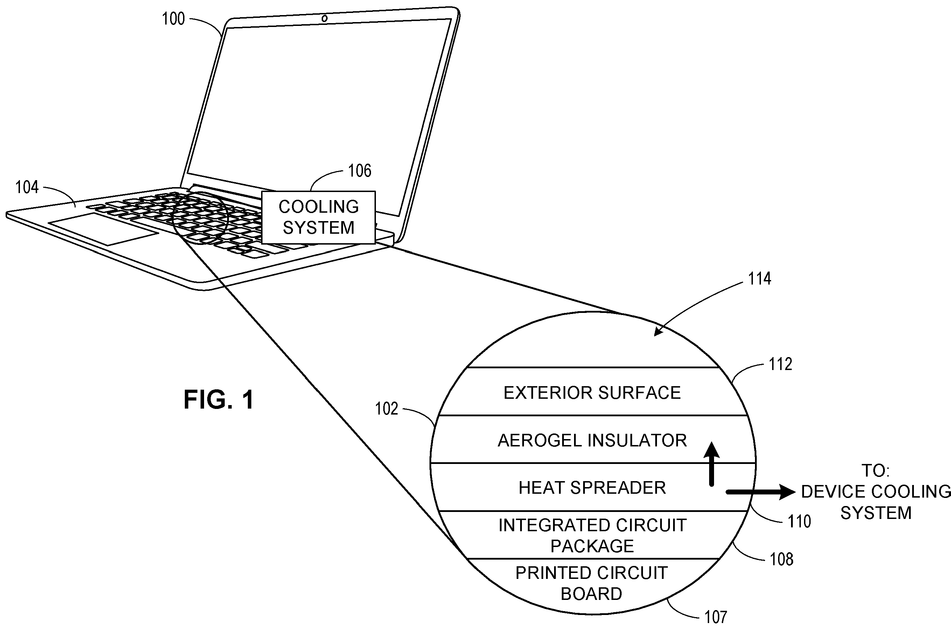

FIG. 1 is a block diagram of an example electronic device 100 that includes an example aerogel insulator 102 implemented in accordance with teachings of this disclosure. In the illustrated example of FIG. 1, the electronic device 100 includes an example housing 104, an example cooling system 106, an example printed circuit board 107, an example integrated circuit package 108, and an example heat spreader 110. In the illustrated example of FIG. 1, the housing 104 includes an example exterior surface 112.

The electronic device 100 is a consumer electronic device. For example, the electronic device 100 can be implemented by any suitable electronic device, including a mobile device (e.g., a cell phone, a smartphone, a tablet, a laptop, a smartwatch, etc.), a personal digital assistant (PDA), a headset (e.g., an augmented reality (AR) headset, a virtual reality (VR) headset, etc.) or another wearable device. In other examples, the electronic device 100 is implemented by another type of computing and/or electronic device, such as a server, a personal computer, a workstation, a self-learning machine (e.g., a neural network), and/or an Internet appliance. In the illustrated example of FIG. 1, the electronic device 100 is operated by the integrated circuit package 108. In some examples, the electronic device 100 includes additional integrated circuit packages similar to the integrated circuit package 108 and/or other compute units.

The housing 104 is the enclosure that contains the components of the electronic device 100. In the illustrated example of FIG. 1, the housing 104 is a rigid shell that protects and encloses the aerogel insulator 102, the printed circuit board 107, the integrated circuit package 108, and the heat spreader 110. In some examples, the housing 104 includes one or more openings to facilitate a fluid flow associated with the cooling system 106 (e.g., an airflow, a coolant flow, etc.) and/or the coupling of one or more cables and/or external devices to a component within the interior of the housing 104. The housing 104 can be composed of any suitable material including a metal (e.g., aluminum, stainless steel, etc.), a plastic (e.g., acrylonitrile butadiene styrene (ABS), polycarbonate, etc.), and/or another material (e.g., a composite, an organic material, etc.). In some examples, the material of the housing 104 and/or the exterior surface 112 can determine the ergonomic limit of the electronic device 100. For example, the ergonomic limit of the housing 104 can be higher if the housing 104 is composed of plastic than if the housing 104 is composed of metal (e.g., hot plastic is more tolerable to the skin of a user than hot metal, etc.).

The exterior surface 112 is a portion of the housing 104. In some examples, the exterior surface 112 is a portion of the housing 104 that is intended (e.g., designed, etc.) to be in contact with the skin of the user of the electronic device 100. In some examples, the exterior surface 112 is the expected hottest portion of the housing 104 during the operation of the electronic device 100 (e.g., determined via observation, determined via modeling, etc.). Additionally or alternatively, the exterior surface 112 is the surface of the housing 104 that is closest to the integrated circuit package 108. In the illustrated example of FIG. 1, the exterior surface 112 abuts the aerogel insulator 102. In other examples, an intermediate layer and/or an air gap is between the aerogel insulator 102 and the exterior surface 112.

In the illustrated example of FIG. 1, the cooling system 106 is incorporated into the electronic device 100. The cooling system 106 cools the electronic device 100 and dissipates heat generated by the operation of components (e.g., processors circuitry, electronics, motors, etc.) of the electronic device 100. In the illustrated example of FIG 1, the cooling system 106 is within the housing 104 of the electronic device 100. In other examples, the cooling system 106 is external to the electronic device 100 (e.g., the cooling system 106 is an external fan, etc.). In some examples, the cooling system 106 is an air-cooling system (e.g., the electronic device 100 is cooled via a forced flow of air induced by a fan, etc.). In other examples, the cooling system 106 can be a liquid cooling system (e.g., an immersion cooling system, etc.).

The integrated circuit package 108 is a compute unit that is mounted on the printed circuit board 107. For example, the integrated circuit package 108 can be a system-on-chip (SOC) package. In some such examples, the integrated circuit package 108 can include a central processing unit (e.g., a processor die, etc.), a graphical processing unit, memory interfaces, input/output (I/O) interfaces, etc. In other examples, the integrated circuit package 108 can be implemented by another type of integrated circuit package (e.g., a central processing unit, a graphic processing unit, a digital signal processor, an accelerator, etc.). In other examples, the integrated circuit package 108 is absent. In some such examples, the electronic device 100 can include a different type of compute unit/integrated circuit that is mounted to the printed circuit board 107 (e.g., a microcontroller, field-programmable gate array (FPGA), etc.). During operation, the integrated circuit package 108 generates heat, which is dissipated by the cooling system 106 and/or into an example ambient environment 114 of the electronic device 100. That is, the integrated circuit package 108 is a heat-generating component.

The heat spreader 110 transfers heat from the integrated circuit package 108 to the cooling system 106. For example, the heat spreader 110 can transfer heat from the integrated circuit package via conduction and/or convection. In some examples, the heat spreader 110 is coupled to the integrated circuit package 108 via a thermally conductive gel. In the illustrated example of FIG. 1, the heat spreader 110 is disposed between the integrated circuit package 108 and the aerogel insulator 102. In some examples, the heat spreader 110 includes a vapor chamber and/or a similar heat-transferring device. In some examples, the heat spreader 110 includes a plurality of heat pipes. In some examples, the heat spreader 110 includes (e.g., is composed of, etc.) a thermally conductive material (e.g., copper, aluminum, brass, silver, diamond, etc.). In some examples, the cooling system 106 is absent and/or external to the housing 104. In some such examples, the heat spreader 110 spreads heat throughout the housing 104 to mitigate the formation of hot spots thereon. In some such examples, the spreading of heat by the heat spreader 110 reduces the likelihood of a particular location of the housing 104 (e.g., the exterior surface 112, etc.) exceeding the ergonomic limit of the electronic device 100.

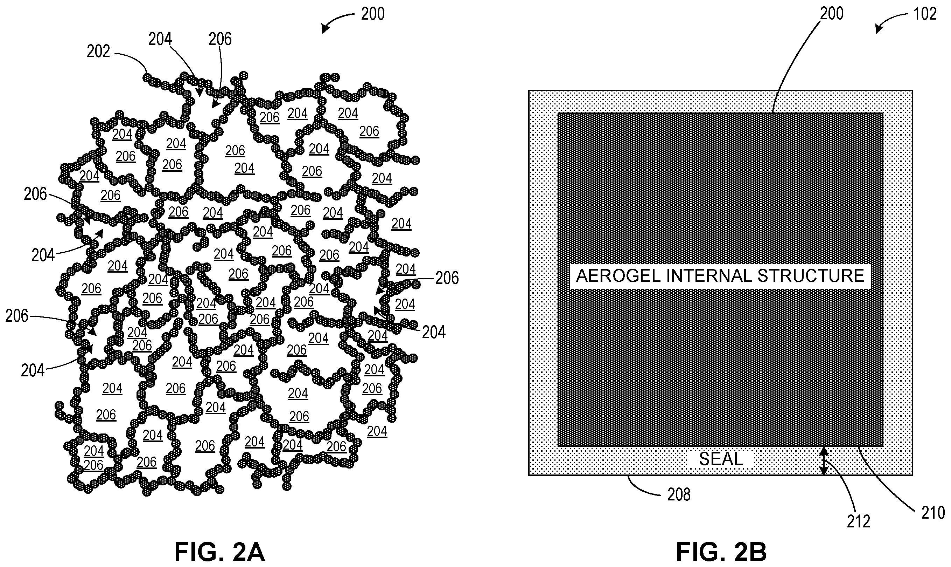

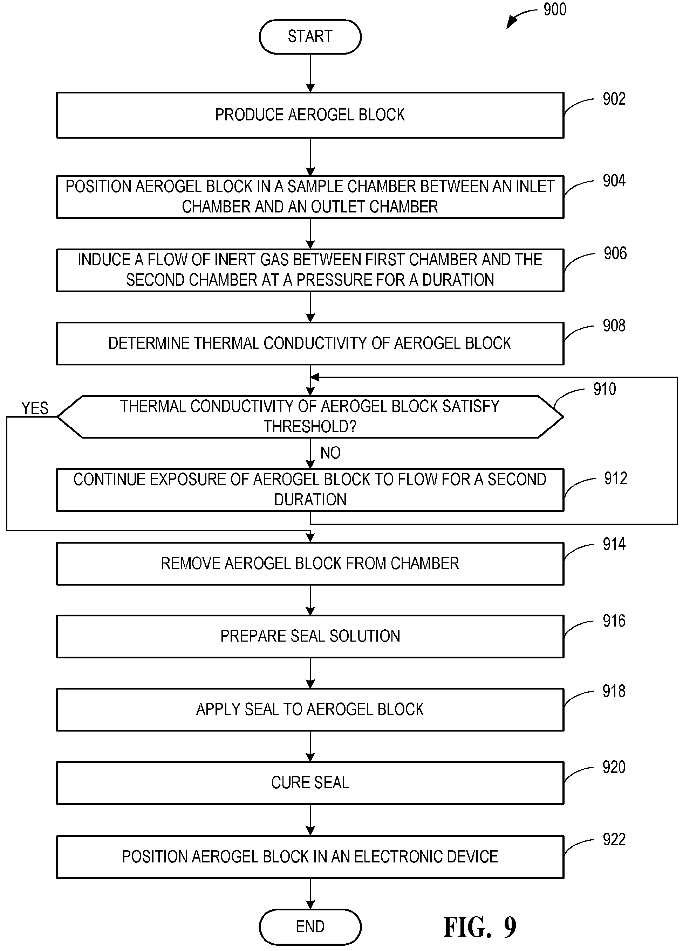

The aerogel insulator 102 is an aerogel block disposed between the integrated circuit package 108 and the exterior surface 112. The aerogel insulator 102 of this example includes aerogel that has been enriched with a gas that has a lower thermal conductivity than that of air. That is, the internal pores (e.g., some of the pores, all of the pores, etc.) of the aerogel of the aerogel insulator 102 include a gas having a lower thermal conductivity than air. In some such examples, the incorporation of such gases into the pores of the aerogel decreases the thermal conductivity of the aerogel insulator 102 when compared to a similar aerogel insulator with pores filled with air. In some examples, the aerogel insulator 102 includes a seal to mitigate (e.g., reduce, prevent, etc.) the leak of the enriched gas in the aerogel insulator 102 into the ambient environment 114. An example implementation of an internal structure of the aerogel insulator 102 of FIG. 1 is described below in conjunction with FIGS. 2A and 2B. Example operations to produce an example implementation of the aerogel insulator 102 of FIG. 1 are described below in conjunction with FIG. 9.

In the illustrated example of FIG. 1, the aerogel insulator 102 is adjacent to and abuts the exterior surface 112 and the aerogel insulator 102 is adjacent to and abuts the heat spreader 110. In the illustrated example of FIG. 1, the aerogel insulator 102 is generally rectangular and has a constant thickness. In other examples, the aerogel insulator 102 can be shaped based on the geometry of the housing 104. In other examples, one or more intermediate layer(s) are disposed between the aerogel insulator 102 and the exterior surface 112 and/or the aerogel insulator 102 and the heat spreader 110. The electronic device 100 can include additional aerogel insulator(s) that are disposed between another surface of the housing 104 and a heat-generating component of the electronic device 100 (e.g., the integrated circuit package 108, etc.).

The heat generated by the integrated circuit package 108 that is transferred through the aerogel insulator 102 increases the temperature of the exterior surface 112. In some examples, the thermal conductivity of the aerogel insulator 102 affects the relative portions of the heat generated by the integrated circuit package 108 that is transferred to the cooling system 106 and the exterior surface 112. That is, the lower the thermal conductivity of the aerogel insulator 102 is, the smaller the portion of the heat transferred to the exterior surface 112. As such, decreasing the thermal conductivity of the aerogel insulator 102 correspondingly decreases the temperature of the exterior surface 112 and/or enables greater junction temperatures and performance of the integrated circuit package 108.

FIG. 2A is a schematic diagram of an example internal structure 200 of the aerogel insulator 102 of FIG. 1. In the illustrated example of FIG. 2A, the internal structure 200 includes an example framework 202 having example pores 204. In the illustrated example of FIG. 2A, the pores 204 include example gas 206 disposed therein. As used herein, the term "pore" refers to the physical openings formed in the framework of an aerogel.

The framework 202 includes one or more crosslinked macromolecules. That is, the framework 202 is composed of one or more covalently bonded large polymers. The framework 202 provides the aerogel insulator 102 with rigidity. In the illustrated example of FIG. 2A, the structure of the framework 202 defines the example pores 204 therein. In the illustrated example of FIG. 2A, some of the pores 204 are open-celled, which does not include the gas 206. In some examples, the framework 202 is mesoporous (e.g., nanoporous, the pores 204 have diameters of between 2 and 50 nanometers, etc.). In other examples, the pores 204 can have any other suitable size. In some examples, the framework 202 includes (e.g., is composed of, etc.) silica ($SiO_2$). That is, the aerogel insulator 102 is a silica aerogel. In some examples, the internal structure 200 is transparent (e.g., fully transparent, partially transparent, etc.) and has a rubber-like surface. In other examples, the framework 202 includes a metal oxide (e.g., the aerogel insulator 102 is a metal oxide aerogel, etc.), an organic polymer (e.g., the aerogel insulator 102 is an organic aerogel, etc.), carbon (e.g., the aerogel insulator 102 is a carbon-based aerogel, etc.), and/or another suitable material.

In the illustrated example of FIG. 2A, the framework 202 is irregular. That is, the pores 204 and the framework 202 do not form an ordered grid and/or an ordered pattern of pores 204. In other examples, the framework 202 can form an ordered lattice structure. In some such examples, all of the pores 204 are closed-celled (e.g., each of the pores 204 is fully surrounded by the framework 202, etc.). It should be appreciated that the framework 202 is not to scale in the illustrated example of FIG. 2A. For example, the volume of the aerogel insulator 102 can be greater than 90% occupied by the pores 204 (e.g., the aerogel insulator is greater than 90% gas by volume, etc.) such that walls of the framework 202 fill the other 10%. It should be appreciated that some of the pores 204 do not include the gas 206. That is, in some examples, some of the pores 204 are filled with air, a different gas, and/or a vacuum.

The gas 206 is disposed within some or all of the pores 204. The gas 206 can include a gas that has a lower thermal conductivity than air. For example, the gas 206 can include an inert gas such as a noble gas, including xenon (Xe), argon (Ar), krypton (Kr), and/or radon (Rn). In other examples, the gas 206 can include another type of inert gas with lower thermal conductivity than that of air, such as carbon dioxide ($CO_2$). In some examples, the gas 206 can include a mixture of gases (e.g., a mixture of carbon dioxide and argon. In other examples, the pores 204 of the aerogel insulator 102 can be filled with a non-inert gas with a lower thermal conductivity than air, such as hydrogen chloride (ClH), nitrous oxide (N2O), dichlorodifluoromethane ($CCl_2F_2$), trichloromethane ($CHCl_3$), etc.

FIG. 2B is a schematic cross-sectional diagram of the aerogel insulator 102 of FIG. 1 including the internal structure 200 of FIG. 2A and an example seal 208. In the illustrated example of FIG. 2B, the seal 208 is disposed on example outer surfaces 210 of the internal structure 200. The outer surfaces 210 of the internal structure 200 are the portion(s) of the framework 202 that is adjacent to the exterior of the framework 202.

The seal 208 prevents the gas 206 of FIG. 2A from leaking from the pores 204 of FIG. 2A during operation. The seal 208 is also referred herein to as a "lining." For example, the seal 208 can include (e.g., be composed of, etc.) a polymer sealant (e.g., a polymer lining, etc.). In some such examples, the seal 208 can include (e.g., be composed of, etc.) a polydimethylsiloxane (PDMS). In some such examples, the seal 208 causes the aerogel insulator 102 to have a glossy (e.g., smooth and reflective, etc.) finish when compared to prior aerogels. In other examples, the seal 208 includes (e.g., is composed of, etc.) another suitable sealant that has a low thermal conductivity. In some examples, the seal 208 is absent.

In the illustrated example of FIG. 2B, the seal 208 has an example thickness 212. In some examples, the thickness 212 is less than about 25 microns. For example, the seal 208 can have a thickness of about 20 microns. In the illustrated example of FIG. 2B, the thickness 212 of the seal 208 is constant along the entirety of the outer surfaces 210 of the internal structure 200 of the aerogel insulator 102. In other examples, the seal 208 has an irregular thickness (e.g., +/- 5 microns, etc.) of the outer surfaces 210 and/or different thickness of different sides of the aerogel insulator 102. In some examples, the seal 208 is disposed on the entirety of the outer surfaces 210 (e.g., all of the exterior of the internal structure 200, etc.). That is, in such examples, the internal structure 200 is fully coated in the seal 208. In other examples, portions of the outer surfaces 210 of the internal structure 200 do not include the seal 208 (e.g., the internal structure 200 is partially coated in the seal 208, etc.). Example operations to deposit the seal 208 on the internal structure 200 of the aerogel insulator 102 are described below in conjunction with FIG. 9.

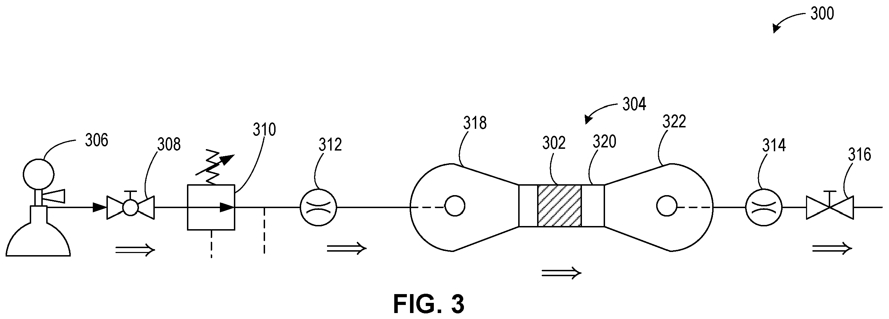

FIG. 3 is a schematic diagram of an example system 300 that can be used to produce the aerogel insulator 102 of FIGS. 1-2B. In the illustrated example of FIG. 3, the system 300 includes an example aerogel block 302 positioned within an example chamber assembly 304 of the system 300. In the illustrated example of FIG. 3, the system 300 includes an example pressurized gas tank 306, an example first valve 308, an example pressure regulator 310, an example first flowmeter 312, an example second flowmeter 314, and an example second valve 316. In the illustrated example of FIG. 3, the chamber assembly 304 includes an example inlet chamber 318, an example sample chamber 320, and an example outlet chamber 322. While an example system 300 for enriching an aerogel block with a gas is depicted in FIG. 3, in other examples, some or all of the components of the systems 300 can be omitted and/or rearranged. Additionally or alternatively, the system 300 can include additional components that are depicted in the illustrated example of FIG. 3.

The gas tank 306 is a pressure vessel that contains a gas that with which aerogel block 302 is to be enriched. For example, the gas tank 306 can contain the gas 206 of FIG. 2A (e.g., the gas to be inserted into the pores 204, etc.). In some examples, the gas tank 306 can include multiple tanks (e.g., a tank bank, etc.). In the illustrated example of FIG. 3, the gas tank 306 is pressurized and contains the gas at a pressure greater than the pressure of the ambient environment.

The first valve 308 controls the flow of pressurized gas from the gas tank 306. For example, opening the first valve 308 enables pressurized gas to leave the gas tank 306 and closing the first valve 308 prevents pressurized gas from leaving the gas tank 306. In some examples, the first valve 308 is a shutoff valve. The second valve 316 controls the flow of gas out of the outlet chamber 322 and out of the system 300. In the illustrated example of FIG. 3, the second valve 316 vents into the ambient environment of the system 300. In other examples, the second valve 316 can be coupled to a recovery system for the system 300. In some such examples, the gas captured by the recovery system can be repressurized and/or purified and reflowed through the system 300. The first valve 308 and/or the second valve 316 can be implemented by a ball valve. In other examples, the first valve 308 can be implemented by a different type of shut-off valve (e.g., a plug valve, a butterfly valve, etc.).

The pressure regulator 310 is a valve that regulates the pressure of the gas leaving the gas tank 306. For example, the pressure regulator 310 can regulate the pressure of the inlet chamber 318 to a fixed pressure such that a pressure differential is maintained through the chamber assembly 304. In some examples, the pressure regulator 310 can be implemented by a flow control valve, such as a sliding stem valve, a rotary valve (e.g., a butterfly valve, a globe valve, etc.), and/or a diaphragm valve.

The flowmeters 312, 314 are sensors that measure the flow rate of gas entering the inlet chamber 318 and exiting the outlet chamber 322, respectively. In some examples, one or both of the flowmeters 312, 314 can be implemented by one or more electromagnetic flowmeter(s), one or more turbine flowmeter(s), one or more vortex flowmeter(s), one or more ultrasonic flowmeter(s), one or more Coriolis flowmeter(s), one or more thermal flow meter(s), one or more volumetric flowmeter(s), one or more float flow meter(s), one or more metal rotor flowmeter(s), one or more open channel flowmeter(s) and/or one or more differential pressure flowmeter(s).

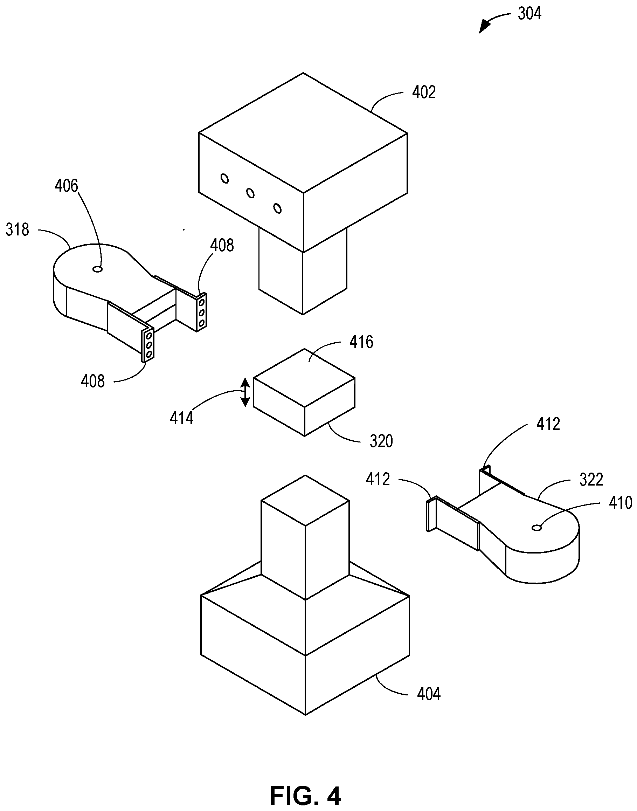

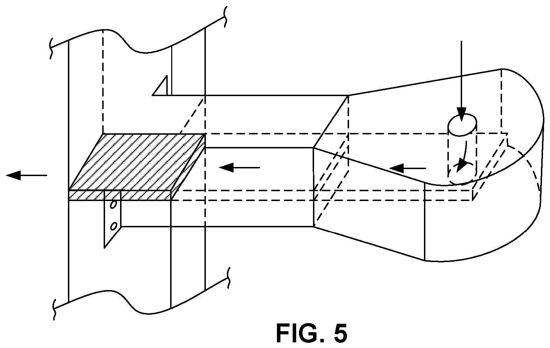

In the illustrated example of FIG. 3, the aerogel block 302 is positioned within the sample chamber 320 of the chamber assembly 304. During operation, pressurized gas enters the chamber assembly 304 and flows sequentially through the inlet chamber 318, then the sample chamber 320, and then the outlet chamber 322. As used herein, the inlet chamber 318 is also referred to interchangeably as "the upstream chamber," "the inlet section," and the "upstream flow section." As used herein, the outlet chamber 322 is also referred to interchangeably as "the downstream chamber," "the outlet section," and the "downstream flow section." The chamber assembly 304 is described below in additional detail in conjunction with FIGS. 4 and 5.

In some examples, to force the flow of the gas through the aerogel block 302, a pressure differential is maintained between the inlet chamber 318 and the outlet chamber 322. In some such examples, the pressure differential between the inlet chamber 318 and the outlet chamber 322 (e.g., the pressure differential over the sample chamber 320, the pressure differential over the aerogel block 302, etc.) is 7 bar. In some examples, to facilitate the absorption of the gas, the aerogel block 302 is exposed to the flow through the chamber assembly 304 for a duration of time. For example, the aerogel block 302 can be exposed to the pressurized gas flow for 96 hrs. In other examples, the aerogel block 302 can be enriched at different pressure differentials and for different durations (e.g., a lower pressure differential and a longer duration, a higher-pressure differential and a shorter duration, etc.). In some such examples, higher pressure differentials between the chambers 318, 322 enable shorter exposure times for the aerogel block 302. In some examples, the pressure differential between the chambers 318, 322 is maintained via the operation of the pressure regulator 310 and the valves 308, 316. In some examples, after removal from the chamber 322, the enriched gas will slowly leak from the aerogel block 302 into the ambient environment. In some such examples, a seal (e.g., the seal 208 of FIG. 2B, etc.) can be disposed on the aerogel block 302 after the aerogel block 302 is removed chamber assembly 304.

FIG. 4 is a perspective partially exploded view of the chamber assembly 304 of the system 300 of FIG. 3 in which an aerogel block can be disposed therein. In the illustrated example of FIG. 4, the chamber assembly 304 includes the inlet chamber 318 of FIG. 3, the sample chamber 320 of FIG. 3, the outlet chamber 322 of FIG. 3, an example first sensor block 402, and an example second sensor block 404. In the illustrated example of FIG. 4, the inlet chamber 318 includes an example inlet 406 and example first brackets 408. In the illustrated example of FIG. 4, the outlet chamber 322 includes an example outlet 410 and example second brackets 412.

In some examples, the first brackets 408 of the inlet chamber 318 can be coupled to the second brackets 412 of the outlet chamber 322. For example, the first brackets 408 can be coupled to the second brackets 412 via one or more fastener(s), one or more weld(s), one or more chemical adhesive(s), and/or one or more interference fit(s). In some examples, the sample chamber 320 is retained between the brackets 408, 412 when the chamber assembly 304 is assembled. In some examples, the sample chamber 320 is absent. In some examples, the aerogel block 302 is retained in compression between the first sensor block 402, the second sensor block 404, the inlet chamber 318, and the outlet chamber 322.

In the illustrated example, the sample chamber 320 is disposed between the first sensor block 402 and the second sensor block 404. During operation of the system 300, the flow of the gas through the pressure differential of the sample chamber 320 causes the air in the pores of the aerogel block 302 to be gradually displaced by the pressurized gas flowing therethrough. That is, longer exposure times of the aerogel block to the flow through the sample chamber 320 increases the number of pores (e.g., the pores 204 of FIG. 2, etc.) filled with the gas associated with the tank 306. The output of the sensor blocks 402, 404 can be used to determine the thermal conductivity of the aerogel block 302 disposed within the sample chamber 320. That is, because the thermal conductivity of the aerogel block 302 decreases as more gas is absorbed thereby, the thermal conductivity of the aerogel block 302 can be used to determine when the aerogel block 302 is saturated with the gas. For example, the thermal conductivity of the aerogel block 302 can be determined via the following equation:

$$k = \frac{QL}{\Delta t A \Delta T} \qquad (1)$$

where k is the thermal conductivity of the aerogel block 302, Q is the heat transferred through the aerogel block 302, L is an example length 414 of the aerogel block 302, A is an example cross-sectional area 416 of the aerogel block 302, and $\Delta T$ is the temperature different between the sensor blocks 402, 404. That is, the thermal conductivity of the aerogel block 302 can be measured by measuring the heat transferred through the aerogel block 302. In some examples, the sensor blocks 402, 404 are absent. In some such examples, the thermal conductivity of the aerogel block 302 can be determined (e.g., estimated, etc.) based on prior operation of the system 300 of FIG. 3.

FIG. 5 is a perspective view of the chamber assembly 304 of FIGS. 3 and 4 depicting the flow of a gas (e.g., an inert gas, etc.) through an aerogel block 302. During operation, pressurized gas enters the chamber assembly 304 via the inlet 406, flows through the inlet chamber 318, flows through the sample chamber 320, flows through the outlet chamber 322, and exits the sample chamber 320 through the outlet 410. In the illustrated example of FIG. 5, the only flow path through the chamber assembly 304 is through the aerogel block 302. While an example geometry of the chamber assembly 304 is depicted in FIG. 5, it should be appreciated that the chamber assembly 304 can have any other suitable geometry.

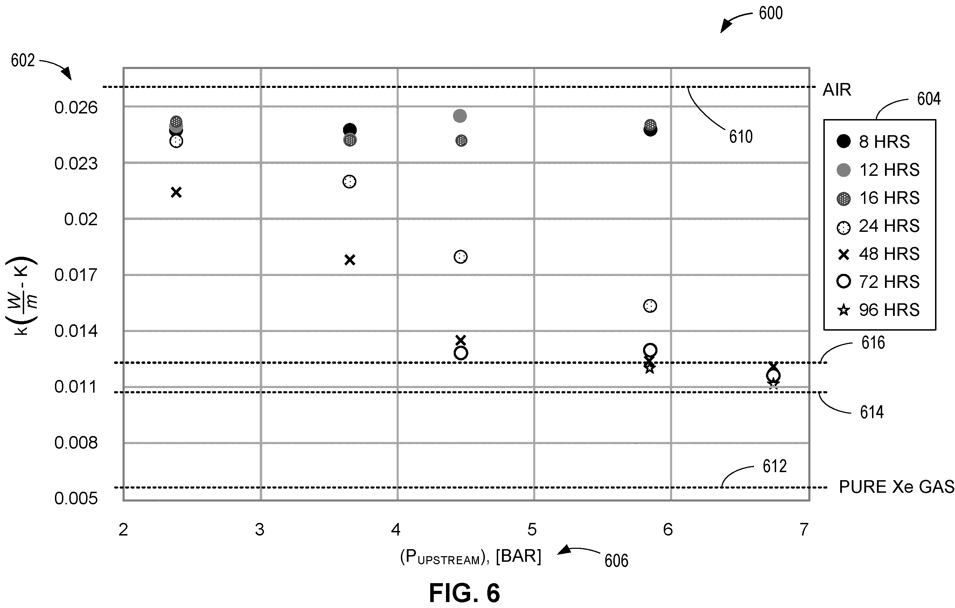

FIG. 6 is an example graph 600 depicting example thermal conductivity 602 of an aerogel sample (e.g., the aerogel block 302 of FIG. 3, etc.) as a function of example exposure time 604 and example pressure 606. The values represented in the graph 600 of FIG. 6 are representative of the enrichment of a silica-based aerogel (e.g., an aerogel sample including a silica framework similar to the framework 202 of FIG. 2A, etc.) with xenon. It should be appreciated that the frameworks of other materials being enriched with other gases may have different relationships than the relationship depicted in the graph 600 of FIG. 6.

In the illustrated example of FIG. 6, the exposure time 604 is represented in the legend, and the pressure 606 is represented on the x-axis. In some examples, the pressure 606 is indicative of the pressure differential between the chambers 318, 322 of the chamber assembly 304 of FIG. 3 (e.g., the pressure differential over the aerogel block 302, etc.). In some examples, the exposure time 604 is representative of the duration of time the aerogel block 302 is exposed to the flow of gas in the sample chamber 320. In the illustrated example of FIG. 6, the thermal conductivity 602 of the aerogel block can be measured by the sensor blocks 402, 404. In the illustrated example of FIG. 6, the graph 600 includes an example first line 610 and an example second line 612. The first line 610 is representative of the thermal conductivity of air (e.g., ~0.026 Watts/meter-Kelvin). The second line 612 is representative of the thermal conductivity of pure xenon gas (e.g., ~0.005 Watts/meter-Kelvin, etc.).

In the illustrated example of FIG. 6, the lower exposure pressures (e.g., 2 bar, 3 bar, etc.) and/or lower exposure times (e.g., 8 hours, 12 hours, 16 hours, 24 hours, etc.) are unsuitable for enriching an aerogel sample with xenon gas. In other examples, longer exposure times 4 (e.g., greater than 96 hours, etc.) and/or greater pressures (e.g., greater than 7 bar, etc.) may enable correspondingly lower pressures (e.g., less than 5 bar, etc.) or corresponding lower exposure times (e.g., less than 24 hours, etc.). F

In the illustrated example of FIG. 6, the thermal conductivity 602 of the aerogel samples converges to an example convergence line 614. The convergence line 614 is also referred to herein as "the saturation line." In the illustrated example of FIG. 6, the convergence line 614 corresponds to a thermal conductivity of approximately 0.0105 Watts/meter-Kelvin. That is, as the exposure time 604 of the exposure to xenon gas and pressure 606 in the chamber assembly increases, the thermal conductivity 602 of the aerogel sample decreases. In some examples, the convergence line 614 represents the thermal conductivity 602 of the aerogel sample in which each of the pores (e.g., the pores 204 of FIG. 2A, etc.) have been enriched (e.g., saturated, etc.) with pockets of xenon gas (e.g., the gas 206 of FIG. 2A, etc.). As such, higher pressures 606 enable shorter exposure times to reach convergence line 614.

In the illustrated example of FIG. 6, the graph 600 includes an example threshold line 616. In some examples, the threshold line 616 represents the target thermal conductivity of the aerogel block. In the illustrated example of FIG. 6, the threshold line 616 corresponds to a thermal conductivity of approximately 0.012 Watts/meter-Kelvin, which is 54% lower than the conductivity of air and 40% lower than the conductivity of unenriched aerogel. In other examples, the threshold line 616 can be set to a different value. For example, the threshold line 616 can be set based on the application of the aerogel block being enriched, based on the material of the aerogel block, the gas being enriched into the aerogel block, and/or as a function of the convergence line 614 (e.g., a thermal conductivity of 120% of the convergence line 614, a thermal conductivity of 115% of the convergence line 614, a thermal conductivity of 101% of the convergence line 614, etc.). In some examples, after the thermal conductivity of an aerogel block (e.g., the aerogel block 302 of FIG. 3, etc.) reaches the threshold line 616, the aerogel block can be removed from the sample chamber 320 and installed in an electronic device (e.g., the electronic device 100 of FIG. 1, etc.) and/or further processed (e.g., depositing a polymer seal thereon, etc.).

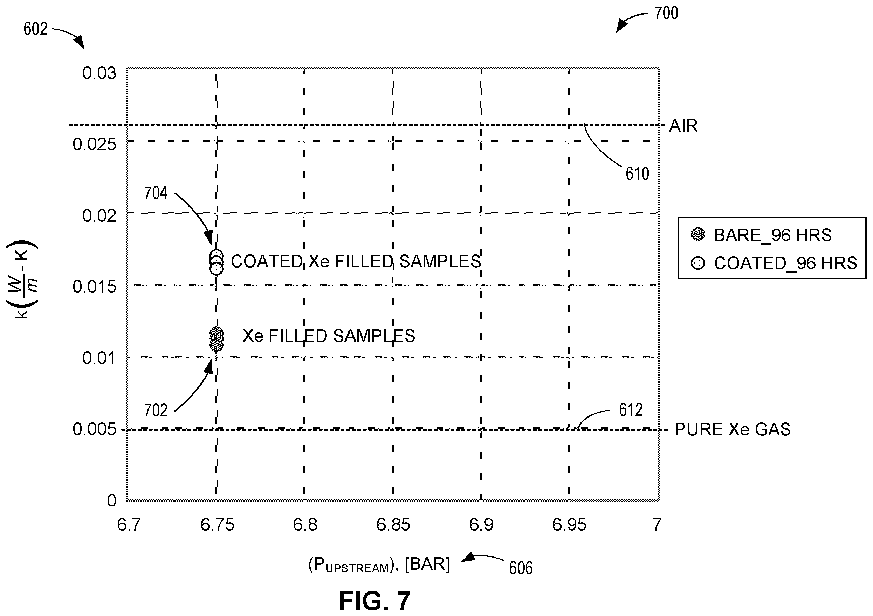

FIG. 7 is an example second graph 700 depicting the difference in the thermal conductivity 602 between an example set of unsealed aerogel blocks 702 and an example set of sealed aerogel blocks 704. The set of unsealed aerogel blocks 702 corresponds to a plurality of aerogel blocks similar to the aerogel block 302 that have been enriched (e.g., saturated, etc.) by the system 300 of FIG. 3 at a pressure of 6.75 bar until the threshold line 614 of FIG. 6 was reached. The set of sealed aerogel blocks 704 corresponds to a plurality of aerogel blocks similar to the aerogel block 302 that have been enriched (e.g., saturated, etc.) by the system 300 of FIG. 3 at a pressure of 6.75 bar until the threshold line 614 of FIG. 6 was reached and sealed with a PDMS seal (e.g., the seal 208 of FIG. 2B, etc.). The thermal conductivity of the sets of aerogel blocks 702, 704 were measured immediately after being enriched via the system 300 of FIG. 3 and the deposition of the seal 208 thereon, respectively.

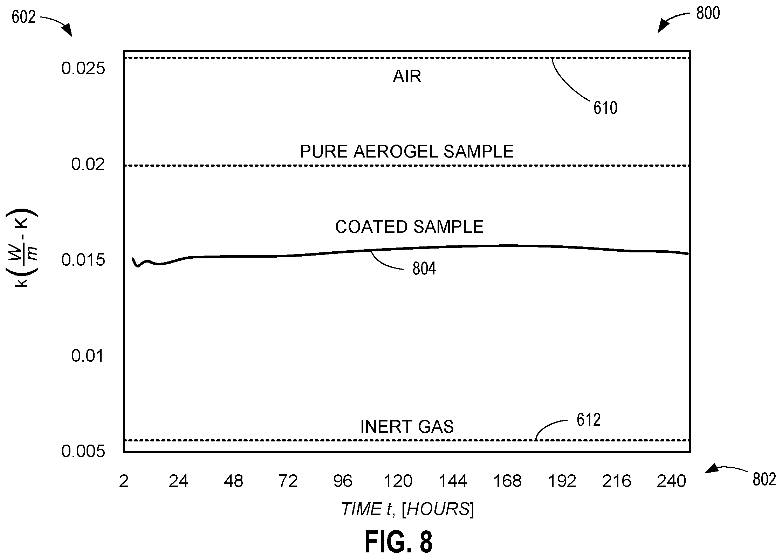

In the illustrated example of FIG. 7, the deposition of the seal 208 on the set of sealed aerogel blocks 704 increases the thermal conductivity thereof (~ 0.016 Watts/meter-Kelvin, etc.) when compared to the thermal conductivity of the set of unsealed aerogel blocks 702 (~ 0.012 Watts/meter-Kelvin, etc.). However, the thermal conductivity of the sealed aerogel blocks 704 is substantially lower than the thermal conductivity of unenriched aerogel (~ 0.020 Watts/meter-Kelvin, etc.) and air (~ 0.030 Watts/meter-Kelvin, etc.). While the deposition of the seal 208 increases the thermal conductivity of the aerogel blocks, the seal 208 prevents the enriched gas from leaking from the set of sealed aerogel blocks 704, which can improve the performance of the set of sealed aerogel blocks 704 over long periods. The benefit of the seal 208 is further described in detail below in conjunction with FIG. 8.

In the illustrated example of FIG. 7, the set of sealed aerogel blocks 704 corresponds to a plurality of aerogel blocks similar to the aerogel block 302 that have been enriched at a pressure of 6.75 bar and, after the deposition of the seal 208, had a thermal conductivity of ~ 0.016 Watts/meter-Kelvin. In some examples, higher pressures can further reduce the thermal conductivity of the aerogel blocks. For example, an exposure pressure of 8.5 bar can yield a plurality of sealed aerogel blocks with a thermal conductivity of ~ 0.014 Watts/-meter-Kelvin. For example, an exposure pressure of 10.1 bar can yield a plurality of sealed aerogel blocks with a thermal conductivity of ~ 0.0125 Watts/meter-Kelvin.

FIG. 8 is an example third graph 800 depicting the thermal conductivity 602 of the set of sealed aerogel blocks 704 of FIG. 7 over example time 802. In the illustrated example of FIG. 8, the thermal conductivity 602 of the set of sealed aerogel blocks 704 of FIG. 7 is represented via an example curve 804. In the illustrated example of FIG. 8, the curve 804 (e.g., the thermal conductivity of sealed aerogel blocks 704, etc.) remains approximately constant over the time 802 at approximately 0.016 Watts/meter-Kelvin. As such, seals, like the seal 208 of FIG. 2B, mitigates (e.g., prevents, substantially reduces, etc.) the leakage of enriched gas from the pores of the sealed aerogel blocks 704 and causes the thermal conductivity of the set of sealed aerogel blocks 704 to be stable over time.

FIG. 9 is a block diagram of example operations 900 for manufacturing the aerogel insulator 102 of FIG. 1 and disposing the aerogel insulator 102 of FIG. 1 into the electronic device 100 of FIG. 1. The operations 900 are described with reference to the system 300 of FIG. 3. It should be appreciated that other systems can be used to manufacture the aerogel insulator 102. The example operations 900 of FIG. 9 begin at block 902, at which the aerogel block 302 of FIG. 3 is produced. For example, the aerogel block 302 can be produced via one or more prior methods of producing aerogel (e.g., gelation, aging, and drying, etc.). In other examples, the aerogel block 302 of FIG. 3 can be acquired commercially. At block 904, the aerogel block 302 is positioned within the sample chamber 320 of FIG. 3 between the inlet chamber 318 of FIG. 3 and the outlet chamber 322 of FIG. 3. For example, the aerogel block 302 can be positioned in the sample chamber 320 such that the only flow path between the chambers 318, 322 is through the aerogel block 302.

At block 906, a flow of gas with a low thermal conductivity is induced between the inlet chamber 318 and the outlet chamber 322 is induced at a pressure for a duration. For example, the flow of gas between the inlet chamber 318 and the outlet chamber 322 can be induced by opening the valves 308, 316 of FIG. 3. In some examples, the flow of gas can be induced at a pressure of between 5 and 8 bars. In some examples, the flow of gas can be induced for a duration of greater than 72 hours (e.g., 96 hours, etc.). In some examples, other pressures and exposure times can be utilized.

At block 908, the thermal conductivity of the aerogel block 302 is determined. For example, the thermal conductivity of the aerogel block 302 can be determined by measuring the sensor blocks 402, 404 of FIG. 4 and equation (1). In other examples, the thermal conductivity of the aerogel block 302 can be determined via a different process. At block 910, it is determined if the thermal conductivity of the aerogel block 302 satisfies a threshold (e.g., a thermal conductivity threshold, etc.). For example, the thermal conductivity of the aerogel block 302 can be compared to the thermal conductivity associated with the threshold line 616 of FIG. 6 (e.g., the threshold is 0.012 Watts/meter-Kelvin, etc.). If the thermal conductivity of the aerogel block 302 satisfies the threshold, the operations 900 advance to block 914. If the thermal conductivity of the aerogel block 302 does not satisfy the threshold, the operations 900 advance to block 912.

At block 912, the exposure of the aerogel block 302 is continued for a second duration. For example, the exposure of the aerogel block 302 can be continued for four hours. In other examples, the exposure can be continued for a different amount of time (e.g., 30 minutes, one hour, 10 hours, etc.). At block 914, the aerogel block 302 is removed from the sample chamber 320 of FIG. 3. At block 916, a seal solution is prepared. For example, if the seal 208 is PDMS, a seal solution can be prepared by dissolving PDMS into a curing agent (e.g., a platinum-based catalyst, etc.). In some such examples, the ratio of PDMS to curing agent can be 9:1 (e.g., nine parts PDMS to 1 part curing agent, etc.). In other examples, the ratio of the sealing polymer to the curing agent can be different (e.g., 1:1, 2:1, 5:1, 10:1, etc.). In some examples, if the PDMS is not to be applied as a liquid, the execution of block 916 is omitted.

At block 918, the seal 208 is applied to the aerogel insulator 102. For example, the seal 208 can be applied to aerogel insulator 102 via spinning coating the seal solution onto to the aerogel insulator 102 until the seal 208 is evenly distributed over the aerogel insulator 102. In other examples, if the seal 208 is not applied as a liquid, the seal 208 can be applied via another suitable method, such as lamination, mechanical spreading, a film deposition process (e.g., physical vapor deposition, chemical vapor deposition, atomic layer deposition, etc.), and/or another suitable process.

At block 920, the seal 208 is cured. For example, the seal 208 can be cured by placing the aerogel insulator 102 in a hot environment for a duration. In some such examples, if the seal 208 includes PDMS, the aerogel insulator 102 can be placed in an oven and/or heater at 80 degrees Celsius for four hours. In other examples, the seal 208 can be cured at a different temperature and/or for a different duration (e.g., if the seal 208 is composed of a different material, etc.). In some examples, the execution of block 920 is omitted. For example, the curing of the seal 208 can be omitted if the seal 208 is deposited as a solid and/or otherwise does not require sealing. After the execution of block 920, the aerogel insulator 102 is in the condition depicted in FIG. 2B.

At block 922, the aerogel insulator 102 is positioned in the electronic device 100 of FIG. 1. For example, the aerogel insulator 102 can be positioned in the electronic device 100 between the exterior surface 112 of FIG. 1 and the heat spreader 110 of FIG. 1. In other examples, the aerogel insulator 102 can be positioned at a different location in the electronic device 100. In some examples, the aerogel insulator 102 is mechanically positioned in the electronic device 100 (e.g., via a pick and place machine, via a technician, etc.). In some examples, the aerogel insulator 102 is fastened to the housing 104 of FIG. 1 (e.g., via a chemical adhesive, via one or more fasteners, etc.). Additionally or alternatively, the aerogel insulator 102 is retained in the aerogel insulator 102 via the compression and/or interference of other components of the electronic device 100. The operations 900 end.

Although the example operations 900 are described with reference to the flowchart illustrated in FIG. 9, many other methods of assembling/manufacturing the aerogel insulator 102 of FIG. 1 may alternatively be used. For example, the order of execution of the blocks may be changed, and/or some of the blocks described may be changed, eliminated, or combined. In some such examples, the seal 208 is not disposed on the aerogel insulator 102 and the execution of blocks 916-920 is not performed. Additionally or alternatively, the seal 208 can be disposed in the sample chamber 320 for a predetermined (e.g., fixed, etc.) duration and the execution of blocks 910 and 912.

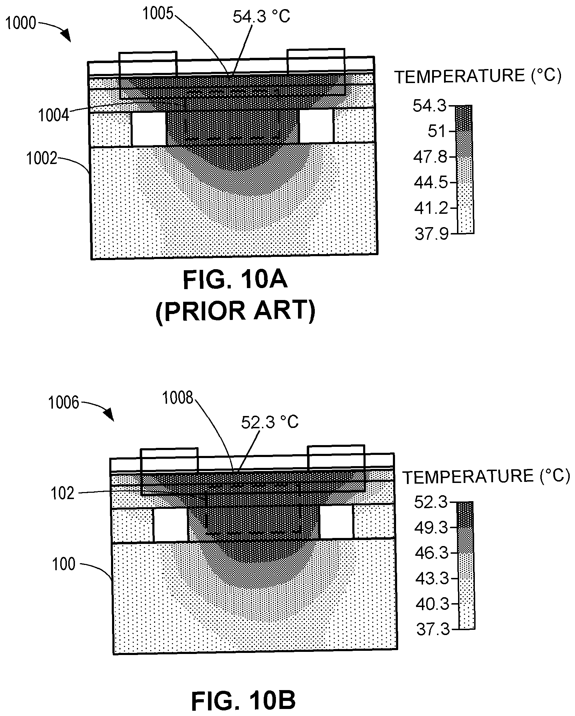

FIG. 10A is a schematic diagram depicting a prior first thermal map 1000 of an electronic device 1002 including a prior aerogel insulator 1004. In FIG. 10A, the prior aerogel block 1004 has a silica framework with pores filled with air. The electronic device 1002 is similar to the electronic device 100 of FIG. 1, except that the electronic device 1002 includes the prior aerogel insulator 1004. In FIG. 10A, the electronic device 1002 has a maximum surface temperature 1005 of 54.3 degrees Celsius.

FIG. 10B is a schematic diagram depicting an example thermal map 1006 of the electronic device 100 of FIG. 1 including the aerogel insulator 102 of FIG. 1. The thermal map 1006 of FIG. 10B is generated under the same operating condition as the electronic devices 100, 1002. In the illustrated example of FIG. 10B, the aerogel insulator 102 has been enriched with xenon and includes a PDMS seal. In other examples, the gas 206 and the seal 208 associated with the aerogel insulator 102 can be implemented by a different gas (e.g., argon, carbon dioxide, etc.) and/or a different sealing material, respectively. In the illustrated example of FIG. 10B, the electronic device 1002 has an example maximum surface temperature 1008 of 52.3 degrees Celsius. The maximum surface temperature 1008 of the electronic device 100 is 7% lower than the maximum surface temperature 1005. That is, the use of the aerogel insulator 102 reduces the maximum surface temperature 1005 of the electronic device 100 when compared to the prior electronic device 1002 including a prior aerogel insulator 1004.

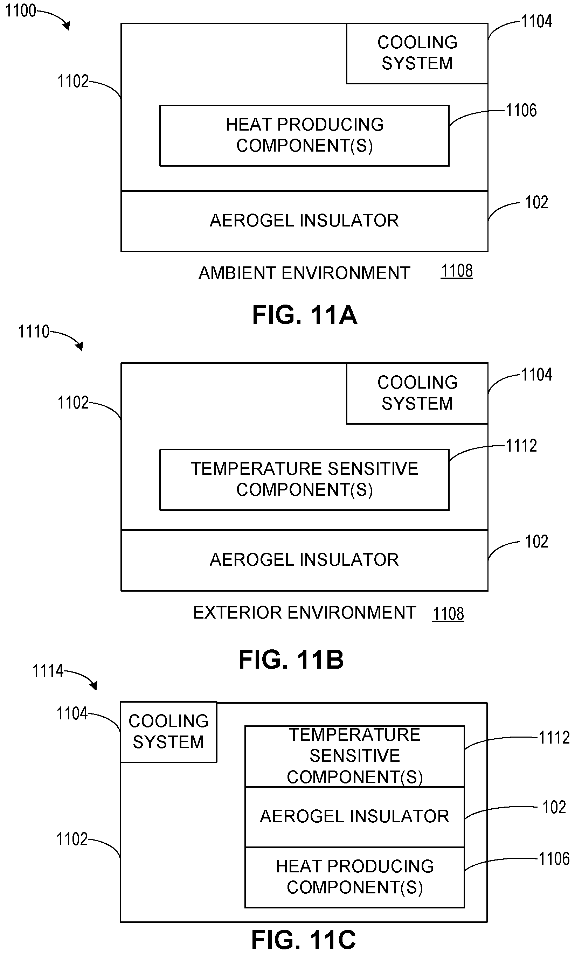

FIG. 11A is a schematic diagram of an example first system 1100 including the aerogel insulator 102 implemented in accordance with the teachings of this disclosure. In the illustrated example of FIG. 11A, the first system 1100 includes an example housing 1102, an example cooling system 1104, and an example heat-producing component(s) 1106. In the illustrated example of FIG. 11A, the first system 1100 is disposed in an example exterior environment 1108. The first system 1100 can include additional components that are not depicted in the illustrated example of FIG. 11A. The first system 1100 can be implemented by an electronic device, a building including heat-producing components (e.g., a factory, a server farm, etc.), an aerospace craft (e.g., an airplane, a drone, a satellite, a manned spacecraft, etc.), and/or any other type of system.

The housing 1102 is a rigid shell that protects and encloses the components of the first system 1100. The housing 1102 can be composed of any suitable material including a metal (e.g., aluminum, stainless steel, etc.), a plastic (e.g., acrylonitrile butadiene styrene (ABS), polycarbonate, etc.), and/or another material (e.g., a composite, an organic material, etc.). Like the cooling system 106 of FIG. 1, the cooling system 1104 cools the first system 1100 and dissipates heat generated by the heat-producing component(s) 1106. In some examples, the cooling system 1104 is an air-cooling system. In other examples, the cooling system 1104 is a liquid cooling system. Additionally or alternatively, the cooling system 1104 is implemented by a passive cooling system (e.g., one or more unpowered cooling fins, one or more unforced convection systems, etc.), a radiative cooling system, one or more ablative cooling systems, etc. In the illustrated example of FIG. 11A, the cooling system 1104 is disposed within the housing 1102. In other examples, the cooling system 1104 can be a discrete apparatus that is external to the housing 1102. The heat-producing component(s) 1106 can be implemented by any suitable components that produce heat, such as processing circuitry (e.g., one or more circuity components mounted on a printed circuit board, etc.), one or more engines (e.g., a combustion engine, an electric motor, a heat engine, a pneumatic motor, a hydraulic motor, etc.), one or more mechanical assemblies that experience friction (e.g., a gearbox, a pulley system, etc.), one or more other electrical systems, etc.

Like the electronic device 100 of FIG. 1, the aerogel insulator 102 increases the relative portion of the heat dissipated by the cooling system 1104 compared to the portion of heat transferred into the housing 1102 and/or the exterior environment 1108. That is, the decreased thermal conductivity of the aerogel insulator 102 when compared to prior aerogel insulator decreases the amount of heat transferred into the exterior environment 1108 and/or enables higher performance (e.g., higher heat generation, etc.) of the heat-producing component(s) 1106. In some examples, the exterior environment 1108 is the ambient environment of the first system 1100 (e.g., outside, a room of a building, outer space, etc.). In other examples, the exterior environment 1108 can be an area that includes temperature-sensitive components and/or people (e.g., a refrigerated area, a cooling room, a room including temperature-sensitive equipment, etc.).

FIG. 11B is a schematic diagram of an example second system 1110 including the aerogel insulator 102 implemented in accordance with the teachings of this disclosure. In the illustrated example of FIG. 11, the first system 1100 includes the housing 1102 of FIG. 11, the cooling system 1104 of FIG. 11, and an example temperature-sensitive component(s) 1112. In the illustrated example of FIG. 11B, the second system 1110 is disposed in the exterior environment 1108 of FIG 11. The second system 1110 can include additional components that are not depicted in the illustrated example of FIG. 11B. In the illustrated example of FIG. 11B, the aerogel insulator 102 is between the temperature-sensitive component(s) 1112 and the exterior environment 1108.

The temperature-sensitive component(s) 1112 (e.g., heat-sensitive component(s), etc.) can be implemented by an area including living organisms (e.g., humans, animals, planets, etc.), food products (e.g., dairy items, produce, meat, other items that spoil in high temperatures, etc.), medical products (e.g., insulin, vaccines, blood, etc.), frozen item, temperature-sensitive electronics, etc. The second system 1110 can be implemented by a building, refrigerator, a freezer, a cooler, a terrestrial vehicle, an aerospace craft, and/or any other suitable type of device.

The aerogel insulator 102 decreases the rate of heat transfer into the temperature-sensitive component(s) 1112 when compared to prior aerogel insulators. The reduced heat transfer from the exterior environment 1108 reduces the power demand associated with the cooling system 1104. For example, the aerogel insulator 102 can reduce the electrical draw of the cooling system 1104 (e.g., reduce the power consumption of the second system 1110, etc.) and/or enable a smaller cooling system 1104 when compared to prior similar systems (e.g., reduce the weight of the second system 1110, reduce the cost of the second system 1110, etc.). In some examples, the second system 1110 does not include the cooling system 1104. In some such examples, the aerogel insulator 102 can increase the time before the temperature-sensitive component(s) 1112 requires active cooling (e.g., enable longer shipping durations for packages, etc.).

FIG. 11C is a schematic diagram of an example third system 1114 including the aerogel insulator 102 implemented in accordance with the teachings of this disclosure. In the illustrated example of FIG. 11C, the third system 1114 includes the housing 1102 of FIGS. 11A and 11B, the cooling system 1104 of FIGS. 11A and 11B, the heat-producing component(s) 1106 of FIG. 11A, and the temperature-sensitive component(s) 1112 of FIG. 11B. The third system 1114 can be implemented by an electronic device, a building an aerospace craft, a refrigerator, a freezer, a cooler, an aerospace craft, and/or any other suitable type of device that includes heat-producing components and temperature-sensitive component(s). In the illustrated example of FIG. 11C, the aerogel insulator 102 is between the heat-producing component(s) 1106 and the temperature-sensitive component(s) 1112.

In the illustrated example of FIG. 11C, the aerogel insulator 102 increases the relative portion of the heat transferred from the heat-producing component(s) 1106 into the housing 1102 and/or cooling system 1104 and decreases the relative portion of the heat transferred from the heat-producing component(s) 1106 into the temperature-sensitive component(s) 1112. As such, like the first system 1100 of FIG. 11A, use of the aerogel insulator 102 in the third system 1114 decreases the amount of heat transferred into the temperature-sensitive component(s) 1112 and/or enables higher performance (e.g., higher heat generation, etc.) of the heat-producing component(s) 1106. Additionally or alternatively, the aerogel insulator 102 reduces the electrical draw of the cooling system 1104 (e.g., the reduction of the power consumption of the third system 1114, etc.) and/or enables a smaller cooling system 1104 when compared to prior similar systems (e.g., reduce the weight of the second system 1110, reduce the cost of the third system 1114, etc.).

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real-world imperfections as will be understood by persons of ordinary skill in the art. For example, "approximately" and "about" may indicate such dimensions may be within a tolerance range of +/- 10% unless otherwise specified herein.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed for aerogel insulators enriched with gas having lower thermal conductivity than air. Disclosed aerogel insulators have substantially lower thermal conductivities than prior aerogel insulators. The reduced thermal conductivity of the aerogel insulators enables higher performance of the integrated circuit packages of electronic devices without exceeding ergonomic temperature limit(s) associated with electronic devices. The reduced thermal conductivity of the aerogel insulators disclosed herein can also reduce the power and/or sizing demands of cooling systems associated with systems including temperature-sensitive systems.

Aerogel including low thermal conductivity gases and related apparatus and methods are disclosed. Further examples and combinations thereof include the following:

Example 1 includes an aerogel including a framework including a plurality of pores, and a gas in at least one of the plurality of pores, the gas having a lower thermal conductivity than air.

Example 2 includes the aerogel of any preceding example, wherein the framework includes silica.

Example 3 includes the aerogel of any preceding example, wherein the gas is an inert gas.

Example 4 includes the aerogel of any preceding example, wherein the inert gas is a noble gas.

Example 5 includes the aerogel of any preceding example, wherein the inert gas includes xenon.

Example 6 includes the aerogel of any preceding example, including a polymer lining on an exterior surface of the framework.

Example 7 includes the aerogel of any preceding example, wherein the polymer lining includes polydimethylsiloxane (PDMS).

Example 8 includes an electronic device including a circuit board, a housing having an exterior surface, and an aerogel insulator between the circuit board and the housing, the aerogel insulator including a gas having a lower thermal conductivity than air.

Example 9 includes the electronic device of any preceding example, wherein the aerogel insulator includes a framework including silica.

Example 10 includes the electronic device of any preceding example, wherein the aerogel insulator is glossy.

Example 11 includes the electronic device of any preceding example, wherein the gas is inert.

Example 12 includes the electronic device of any preceding example, wherein the gas is xenon.

Example 13 includes the electronic device of any preceding example, wherein the exterior surface is to be in contact with a user.

Example 14 includes the electronic device of any preceding example, including a polymer lining on the exterior surface of the aerogel insulator.

Example 15 includes the electronic device of any preceding example, wherein the polymer lining includes polydimethylsiloxane (PDMS).

Example 16 includes the electronic device of any preceding example, wherein the polymer lining has a thickness of less than about 25 microns.

Example 17 includes an apparatus comprising a housing an aerogel insulator including an inert gas, and at least one of a temperature-sensitive component or a heat-producing component.

Example 18 includes the apparatus of any preceding example, wherein the aerogel insulator is between the temperature-sensitive component and the heat-producing component.

Example 19 includes the apparatus of any preceding example, wherein the aerogel insulator is between at least one of the temperature-sensitive component or the heat-producing component and an exterior environment.

Example 20 includes the apparatus of any preceding example, wherein the inert gas includes xenon, and the aerogel insulator includes a silica framework, an outer surface, and a polymer lining on the outer surface.

Example 21 includes a method comprising inducing a flow of a gas through a chamber including an aerogel block, the gas having a lower thermal conductivity than air, removing the aerogel block from the chamber, and applying a seal on an outer surface of the aerogel block.

Example 22 includes the method of any preceding example, further including determining a thermal conductivity of the aerogel block, determining the thermal conductivity satisfies a threshold, and the removing the aerogel block from the chamber after determining the thermal conductivity satisfies the threshold.

Example 23 includes the method of any preceding example, wherein the seal is applied via spinning coating.

Example 24 includes the method of any preceding example, further including positioning the aerogel block in an electronic device.

Example 25 includes the method of any preceding example, wherein the inducing the flow of the gas includes inducing the flow of the gas for at least 24 hours.

Example 26 includes the method of any preceding example, wherein the inducing the flow of the gas includes inducing the flow of the gas at a pressure differential of at least 7 bar.

Example 27 includes the method of any preceding example, wherein the gas is xenon.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An electronic device including:

   a circuit board;
   a housing having an exterior surface; and
   an aerogel insulator between the circuit board and the housing, the aerogel insulator including a gas having a lower thermal conductivity than air.

2. The electronic device of claim 1, wherein the aerogel insulator includes a framework including silica.

3. The electronic device of any preceding claim, wherein the aerogel insulator is glossy.

4. The electronic device of any preceding claim, wherein the gas is inert.

5. The electronic device of claim 4, wherein the gas is xenon.

6. The electronic device of any preceding claim, wherein the exterior surface is to be in contact with a user.

7. The electronic device of any preceding claim, including a polymer lining on the exterior surface of the aerogel insulator.

8. The electronic device of claim 7, wherein the polymer lining includes polydimethylsiloxane (PDMS).

9. The electronic device of claim 8, wherein the polymer lining has a thickness of less than about 25 microns.

10. A method comprising:

    inducing a flow of a gas through a chamber including an aerogel block, the gas having a lower thermal conductivity than air;
    removing the aerogel block from the chamber; and
    applying a seal on an outer surface of the aerogel block.

11. The method of claim 10, further including:

    determining a thermal conductivity of the aerogel block;
    determining the thermal conductivity satisfies a threshold; and
    the removing the aerogel block from the chamber after determining the thermal conductivity satisfies the threshold.

12. The method of any one of claims 10-11, wherein the seal is applied via spinning coating.

13. The method of any one of claims 10-12, further including positioning the aerogel block in an electronic device.

14. The method of any one of claims 10-13, wherein the inducing the flow of the gas includes inducing the flow of the gas for at least 24 hours at a pressure differential of at least 7 bar.

15. The method of any one of claims 10-14, wherein the

**EP 4 671 922 A1**

gas is xenon.

114

112

TO:
DEVICE COOLING
SYSTEM

EXTERIOR SURFACE

AEROGEL INSULATOR

HEAT SPREADER

INTEGRATED CIRCUIT
PACKAGE

PRINTED CIRCUIT
BOARD

110

108

107

102

100

106

COOLING
SYSTEM

104

**FIG. 1**

102

200

AEROGEL INTERNAL STRUCTURE

210

212

SEAL

208

**FIG. 2B**

200

206
204
202
206

**FIG. 2A**

FIG. 3

FIG. 4

FIG. 5

FIG. 6

FIG. 7

**FIG. 8**

EP 4 671 922 A1

900

START

PRODUCE AEROGEL BLOCK — 902

POSITION AEROGEL BLOCK IN A SAMPLE CHAMBER BETWEEN AN INLET CHAMBER AND AN OUTLET CHAMBER — 904

INDUCE A FLOW OF INERT GAS BETWEEN FIRST CHAMBER AND THE SECOND CHAMBER AT A PRESSURE FOR A DURATION — 906

DETERMINE THERMAL CONDUCTIVITY OF AEROGEL BLOCK — 908

THERMAL CONDUCTIVITY OF AEROGEL BLOCK SATISFY THRESHOLD? — 910

YES

NO

CONTINUE EXPOSURE OF AEROGEL BLOCK TO FLOW FOR A SECOND DURATION — 912

REMOVE AEROGEL BLOCK FROM CHAMBER — 914

PREPARE SEAL SOLUTION — 916

APPLY SEAL TO AEROGEL BLOCK — 918

CURE SEAL — 920

POSITION AEROGEL BLOCK IN AN ELECTRONIC DEVICE — 922

END

**FIG. 9**

FIG. 10A
(PRIOR ART)

FIG. 10B

FIG. 11A

FIG. 11B

FIG. 11C

Europäisches
Patentamt

European
Patent Office

Office européen
des brevets

# EUROPEAN SEARCH REPORT

**Application Number**

EP 25 17 8437

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2006/196689 A1 (RISTIC-LEHMANN CEDOMILA [US] ET AL) 7 September 2006 (2006-09-07) <br> * abstract; figures 4,9,10 * <br> * paragraphs [0001] - [0002], [0008] - [0012], [0025] - [0057] * <br> ----- | 1-9 | INV. <br> G06F1/20 <br> C01B33/158 <br> C01B33/159 <br> C08G77/02 <br> C08G77/04 <br> C09D183/04 |
| X | US 2018/328648 A1 (ADACHI GO [JP] ET AL) 15 November 2018 (2018-11-15) | 10-15 | |
| Y | * abstract; figures 1A-4 * <br> * paragraphs [0001], [0007] - [0021], [0045] - [0071] * <br> ----- | 1-9 | |

|  | TECHNICAL FIELDS SEARCHED (IPC) |
|---|---|
|  | G06F <br> C01B <br> C08G <br> C09D |

The present search report has been drawn up for all claims

| Place of search | Date of completion of the search | Examiner |
|---|---|---|
| The Hague | 5 November 2025 | París Martín, Laura |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**Application Number**

EP 25 17 8437

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

Application Number

EP 25 17 8437

The Search Division considers that the present European patent application does not comply with the requirements of unity of invention and relates to several inventions or groups of inventions, namely:

        1. claims: 1-15

            -

        1.1. claims: 1-9

                Electronic device with an aerogel insulator including a gas having a lower thermal conductivity than air.

        1.2. claims: 10-15

                Method of inducing gas with a lower thermal conductivity than air into an aerogel block and applying a seal to the block.
                        ---

Please note that all inventions mentioned under item 1, although not necessarily linked by a common inventive concept, could be searched without effort justifying an additional fee.

## ANNEX TO THE EUROPEAN SEARCH REPORT
## ON EUROPEAN PATENT APPLICATION NO.

EP 25 17 8437

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2025

| Patent document cited in search report | Publication date | Patent family member(s) | | Publication date |
|---|---|---|---|---|
| US 2006196689 A1 | 07-09-2006 | CA | 2543386 A1 | 26-05-2005 |
| | | CA | 2733298 A1 | 26-05-2005 |
| | | CN | 1875060 A | 06-12-2006 |
| | | DK | 1682611 T3 | 09-05-2016 |
| | | DK | 2615132 T3 | 27-03-2017 |
| | | DK | 2617761 T3 | 06-06-2016 |
| | | EP | 1682611 A1 | 26-07-2006 |
| | | EP | 2615132 A1 | 17-07-2013 |
| | | EP | 2617761 A1 | 24-07-2013 |
| | | HK | 1088624 A1 | 10-11-2006 |
| | | JP | 5336531 B2 | 06-11-2013 |
| | | JP | 5654437 B2 | 14-01-2015 |
| | | JP | 5857174 B2 | 10-02-2016 |
| | | JP | 2007510794 A | 26-04-2007 |
| | | JP | 2011098573 A | 19-05-2011 |
| | | JP | 2012107241 A | 07-06-2012 |
| | | JP | 2013139150 A | 18-07-2013 |
| | | PL | 1682611 T3 | 29-07-2016 |
| | | PL | 2615132 T3 | 30-06-2017 |
| | | PL | 2617761 T3 | 30-09-2016 |
| | | US | 2005100728 A1 | 12-05-2005 |
| | | US | 2005143515 A1 | 30-06-2005 |
| | | US | 2006196689 A1 | 07-09-2006 |
| | | US | 2006196690 A1 | 07-09-2006 |
| | | US | 2006240237 A1 | 26-10-2006 |
| | | US | 2007176282 A1 | 02-08-2007 |
| | | US | 2008105373 A1 | 08-05-2008 |
| | | US | 2008131683 A1 | 05-06-2008 |
| | | WO | 2005047381 A1 | 26-05-2005 |
| US 2018328648 A1 | 15-11-2018 | KR | 20180124706 A | 21-11-2018 |
| | | US | 2018328648 A1 | 15-11-2018 |
| | | WO | 2018208090 A1 | 15-11-2018 |

EPO FORM P0459

For more details about this annex : see Official Journal of the European Patent Office, No. 12/82